# EUROPEAN PATENT APPLICATION

(11) **EP 4 842 168 A1**
(43) Date of publication of application: **18.11.2026**
(21) Application number: 25879264.7
(22) Date of filing: 30.09.2025
(51) Int. Cl.: H10F 77/20

(54) **PHOTOVOLTAIC CELL, MODULE AND SYSTEM**

(30) Priority: 18.10.2024 CN 202422539827 U
(71) Applicant: Zhejiang Aiko Solar Technology Co., Ltd, Jinhua, Zhejiang 322009 (CN)
(72) Inventor: LI, Yuming, Jinhua, Zhejiang 322009 (CN)
(74) Representative: EP&C
(86) International application number: PCT/CN2025/125965
(87) International publication number: WO 2026/081883

(57) **Abstract**

The present disclosure provides a photovoltaic cell, a assembly, and a system. A back surface of a silicon wafer of the cell is provided with first polarity doped layers and second polarity doped layers that are alternately arranged in a spaced manner, and the second polarity doped layers are spaced from the first polarity doped layers by spacing zones. First isolated doped parts that are not in contact with the first polarity doped layers and the second polarity doped layers are arranged in the spacing zones.

## Description

### Cross-Reference to Related Application

The present disclosure claims the priority to the Chinese Patent Application No. 202422539827.1 filed with the China National Intellectual Property Administration on October 18, 2024 and entitled "Back contact solar cell, cell assembly, and photovoltaic system", which is incorporated in its entirety herein by reference.

### Technical Field

The present disclosure relates to the technical field of solar cells, and particularly relates to a back contact solar cell, a cell assembly, and a photovoltaic system.

### Background

At present, in solar cells, a back contact solar cell is a cell with an emitter and a base on a back surface (a non-light-receiving surface), and a light-receiving surface of the cell is not shielded by any metal electrode, thus effectively increasing short-circuit currents of the cell.

In the related art, a P-type doped layer and an N-type doped layer are arranged on the back surface of the back contact solar cell, and the P-type doped layer and the N-type doped layer are isolated by an isolation zone (such as a groove), thus avoiding short-circuit leakage. However, in the related art, carriers can easily be recombined in the isolation zone, and a collection rate of the carriers is low. In view of this, efficiency of the back contact solar cell needs to be further improved.

### Summary

The present disclosure provides a back contact solar cell, a cell assembly, and a photovoltaic system.

The present disclosure is implemented as follows: A back contact solar cell according to an example of the present disclosure includes:
a silicon wafer, where the silicon wafer has a front surface and a back surface opposite each other, the back surface includes first zones and second zones that are alternately and sequentially configured in a first direction in a spaced manner, the first zones and the second zones extend in a second direction, spacing zones are configured between adjacent the first zones and the second zones, and the second direction intersects with the first direction; first polarity doped layers stacked on the first zones; second polarity doped layers stacked on the second zones, where polarities of the second polarity doped layers are different from polarities of the first polarity doped layers; and a plurality of first isolated doped parts, where the plurality of first isolated doped parts are independently arranged in the spacing zones and are spaced from the first polarity doped layers and the second polarity doped layers, and polarities of the first isolated doped parts are the same as the polarities of the first polarity doped layers.

In some examples, in the first direction, a distance between the first isolated doped parts and the first polarity doped layers is greater than or equal to 300 nm.

In some examples, in the first direction, a distance between the first isolated doped parts and the second polarity doped layers is greater than or equal to 300 nm.

In some examples, the plurality of first isolated doped parts are randomly distributed and arranged on the spacing zones; or
the plurality of first isolated doped parts are arranged on the spacing zones in the second direction in a spaced manner.

In some examples, in a case that the plurality of first isolated doped parts are arranged on the spacing zones in the second direction in a spaced manner, a distance between two adjacent the first isolated doped parts is 30 µm to 380 µm in the second direction.

In some examples, a ratio of an orthographic projection area of all the first isolated doped parts in the single spacing zone in a thickness direction of the silicon wafer to an orthographic projection area of the single spacing zone in the thickness direction of the silicon wafer is 0.0001 to 0.5.

In some examples, a ratio of an orthographic projection area of all the first isolated doped parts in the single spacing zone in a thickness direction of the silicon wafer to an orthographic projection area of the single spacing zone in the thickness direction of the silicon wafer is 0.001 to 0.1.

In some examples, a thickness of the first isolated doped parts is 20 nm to 450 nm.

In some examples, a plurality of first arc-shaped concave zones are formed on side wall surfaces of the first polarity doped layers adjacent to the spacing zones, the plurality of first arc-shaped concave zones are configured in the second direction, two adjacent the first arc-shaped concave zones intersect with each other, and the first isolated doped part is arranged near a junction of two adjacent the first arc-shaped concave zones.

In some examples, in the spacing zones, the silicon wafer is provided with first isolated protrusions, and the first isolated doped parts are arranged on the first isolated protrusions and cover at least partial zones of the first isolated protrusions.

In some examples, the first isolated doped parts completely cover the first isolated protrusions, and the first isolated doped parts have first suspended sections extending out of the first isolated protrusions and suspended in the spacing zones.

In some examples, surfaces of the first suspended sections facing the silicon wafer are provided with second isolated doped parts, and polarities of the second isolated doped parts are different from the polarities of the first polarity doped layers and are the same as the polarities of the second polarity doped layers.

In some examples, the second isolated doped parts are insulated from the first suspended sections.

In some examples, the second isolated doped parts further extend along side surfaces of the first isolated protrusions to zones, shielded by the first suspended sections, of the silicon wafer.

In some examples, side surfaces of the first isolated protrusions are provided with third isolated doped parts, and the third isolated doped parts are spaced from the first isolated doped parts.

In some examples, zones, shielded by the first suspended sections, of the silicon wafer are provided with fourth isolated doped parts, polarities of the fourth isolated doped parts are the same as the polarities of the second polarity doped layers, and the fourth isolated doped parts are spaced from the first polarity doped layers and the second polarity doped layers.

In some examples, the fourth isolated doped parts are spaced from the first isolated protrusions and the first isolated doped parts.

In some examples, in the first direction, a distance between the fourth isolated doped parts and the first isolated protrusions is 0.1 µm to 200 µm.

In some examples, the back contact solar cell further includes a plurality of fifth isolated doped parts. The plurality of fifth isolated doped parts are arranged in the spacing zones. The fifth isolated doped parts are spaced from the first polarity doped layers and the second polarity doped layers. Polarities of the fifth isolated doped parts are the same as the polarities of the second polarity doped layers.

In some examples, the fifth isolated doped parts are spaced from the first isolated doped parts in the spacing zones.

In some examples, a distance between any one of the fifth isolated doped parts and any one of the first isolated doped parts is greater than or equal to 0.1 µm to 200 µm.

In some examples, in the first direction, a distance between the fifth isolated doped parts and the second polarity doped layers is greater than or equal to 300 nm.

In some examples, in the first direction, a distance between the fifth isolated doped parts and the first polarity doped layers is greater than or equal to 300 nm.

In some examples, the plurality of fifth isolated doped parts are randomly distributed and arranged on the spacing zones; or
the plurality of fifth isolated doped parts are arranged on the spacing zones in the second direction in a spaced manner.

In some examples, in a case that the plurality of fifth isolated doped parts are arranged on the spacing zones in the second direction in a spaced manner, a distance between two adjacent the fifth isolated doped parts is 30 µm to 380 µm.

In some examples, a ratio of an orthographic projection area of all the fifth isolated doped parts in the single spacing zone in a thickness direction of the silicon wafer to an orthographic projection area of the single spacing zone in the thickness direction of the silicon wafer is 0.0001 to 0.5.

In some examples, a ratio of an orthographic projection area of all the fifth isolated doped parts in the single spacing zone in a thickness direction of the silicon wafer to an orthographic projection area of the single spacing zone in the thickness direction of the silicon wafer is 0.001 to 0.1.

In some examples, a thickness of the fifth isolated doped parts is 20 nm to 450 nm.

In some examples, a plurality of second arc-shaped concave zones are formed on side wall surfaces of the second polarity doped layers adjacent to the spacing zones, the plurality of second arc-shaped concave zones are configured in the second direction, two adjacent second the arc-shaped concave zones intersect with each other, and the fifth isolated doped parts are arranged near a junction of two adjacent s the econd arc-shaped concave zones.

In some examples, grooves are formed in the spacing zones, the grooves are internally provided with second isolated protrusions, and the fifth isolated doped parts are arranged on the second isolated protrusions and cover at least partial zones of the second isolated protrusions.

In some examples, the fifth isolated doped parts only cover partial zones of the second isolated protrusions; or the fifth isolated doped parts completely cover the second isolated protrusions, and the fifth isolated doped parts have second suspended sections extending out of the second isolated protrusions and suspended in the spacing zones.

In some examples, on at least part of the first polarity doped layers, the first polarity doped layers have third suspended sections extending to positions above the spacing zones, the third suspended sections are suspended above part of the spacing zones, and the first isolated doped parts are arranged on zones, not shielded by the third suspended sections, of the spacing zones.

In some examples, surfaces of the third suspended sections facing the silicon wafer are provided with sixth isolated doped parts, and polarities of the sixth isolated doped parts are the same as the polarities of the second polarity doped layers.

In some examples, zones, shielded by the third suspended sections, of the silicon wafer are provided with seventh isolated doped parts, the seventh isolated doped parts are spaced from the first polarity doped layers and the second polarity doped layers, and polarities of the seventh isolated doped parts are the same as the polarities of the second polarity doped layers.

In some examples, the seventh isolated doped parts are spaced from the first isolated doped parts.

In some examples, the silicon wafer is provided with silicon wafer extending parts extending to the spacing zones and suspended in the spacing zones, and at least part of the third suspended sections are stacked on the silicon wafer extending parts.

In some examples, surfaces of the silicon wafer extending parts facing away from the third suspended sections are provided with eighth isolated doped parts, and polarities of the eighth isolated doped parts are the same as the polarities of the second polarity doped layers.

In some examples, the eighth isolated doped parts are spaced from the first isolated doped parts.

The present disclosure further provides a cell assembly. The cell assembly includes the back contact solar cell according to any one of the above examples.

The present disclosure further provides a photovoltaic system. The photovoltaic system includes the above cell assembly.

In the back contact solar cell, the cell assembly, and the photovoltaic system according to the examples of the present disclosure, the back surface of the silicon wafer is provided with the first zones and the second zones that are alternately configured in a spaced manner, the first zones are spaced from the second zones by the spacing zones, the first polarity doped layers are stacked on the first zones, the second polarity doped layers are stacked on the second zones, and the second polarity doped layers are spaced from the first polarity doped layers by the spacing zones. The plurality of first isolated doped parts independent of the first polarity doped layers and the second polarity doped layers are arranged in the spacing zones. The first isolated doped parts are not in contact with the first polarity doped layers and the second polarity doped layers. In this way, electrical isolation between the first polarity doped layers and the second polarity doped layers can be ensured through the arrangement of the spacing zones, and short circuit can be avoided. Meanwhile, the plurality of independent first isolated doped parts are arranged in the spacing zones, and the first isolated doped parts may form floating junction passivation in the spacing zones, such that a passivation effect of the spacing zones can be improved, thus improving efficiency of the back contact solar cell. In addition, a collection rate of carriers can be improved by arranging the independent first isolated doped parts in the spacing zones.

Additional aspects and advantages of the present disclosure will be set forth partially in the following description, which will become obvious in the following description, or can be learned by practice of the present disclosure.

### Brief Description of the Drawings

Fig. 1 is a schematic block diagram of a photovoltaic system according to an example of the present disclosure;
Fig. 2 is a schematic block diagram of a cell assembly according to an example of the present disclosure;
Fig. 3 is a schematic diagram of a planer structure of a back contact solar cell according to an example of the present disclosure;
Fig. 4 is a schematic diagram of a sectional structure of a back contact solar cell according to an example of the present disclosure;
Fig. 5 is a schematic diagram of another planer structure of a back contact solar cell according to an example of the present disclosure;
Fig. 6 is a schematic diagram of another sectional structure of a back contact solar cell according to an example of the present disclosure;
Fig. 7 is a schematic diagram of yet another sectional structure of a back contact solar cell according to an example of the present disclosure;
Fig. 8 is a schematic diagram of yet another sectional structure of a back contact solar cell according to an example of the present disclosure;
Fig. 9 is a schematic diagram of yet another planer structure of a back contact solar cell according to an example of the present disclosure;
Fig. 10 is a schematic diagram of yet another sectional structure of a back contact solar cell according to an example of the present disclosure;
Fig. 11 is a schematic diagram of still another planer structure of a back contact solar cell according to an example of the present disclosure;
Fig. 12 is a schematic diagram of yet another sectional structure of a back contact solar cell according to an example of the present disclosure;
Fig. 13 is a schematic diagram of yet another sectional structure of a back contact solar cell according to an example of the present disclosure;
Fig. 14 is a schematic diagram of yet another sectional structure of a back contact solar cell according to an example of the present disclosure;
Fig. 15 is a schematic diagram of yet another sectional structure of a back contact solar cell according to an example of the present disclosure;
Fig. 16 is a schematic diagram of yet another sectional structure of a back contact solar cell according to an example of the present disclosure; and
Fig. 17 is a schematic diagram of still another sectional structure of a back contact solar cell according to an example of the present disclosure.

Description of symbols of main elements:
photovoltaic system 1000, cell assembly 200, back contact solar cell 100, silicon wafer 10, front surface 11, back surface 12, first zone 121, second zone 122, spacing zone 123, first isolated protrusion 1231, groove 1232, second isolated protrusion 1233, first polarity doped layer 20, first arc-shaped concave zone 21, second polarity doped layer 30, first isolated doped part 40, first suspended section 41, back passivation film layer 50, first electrode 60, second electrode 70, second isolated doped part 80, third isolated doped part 90, fourth isolated doped part 110, fifth isolated doped part 120, second suspended section 1201, and third suspended section 22.

### Detailed Description of the Embodiments

For making objectives, technical solutions and advantages of the present disclosure clearer, the present disclosure will be further described in detail below in conjunction with accompanying drawings and examples. Instances of the examples are shown in the accompanying drawings, throughout which identical or similar reference numerals denote identical or similar elements or elements having identical or similar functions. The examples described with reference to the accompanying drawings are illustrative and only intended to explain the present disclosure, instead of limiting the present disclosure. In addition, it should be understood that specific examples described herein are merely used to explain the present disclosure, and are not used to limit the present disclosure.

In the description of the present disclosure, it should be understood that orientations or positional relationships indicated by the terms such as "length", "width", "upper", "lower", "transverse", and "longitudinal" are based on orientations or positional relationships shown in the accompanying drawings, are merely for facilitating the description of the present disclosure and simplifying the description, rather than indicating or implying that a device or element referred to must have a particular orientation or must be constructed and operated in a particular orientation, and therefore cannot be interpreted as limiting the present disclosure.

In addition, the terms "first" and "second" are merely for descriptive purposes and are not to be construed as indicating or implying their relative importance or implicitly specifying a quantity of indicated technical features. Thus, features defined with "first" and "second" may explicitly or implicitly include one or more of the features. In the description of the present disclosure, "plurality" means two or more, unless expressly specified otherwise.

In the description of the present disclosure, it should be noted that, unless expressly specified and defined otherwise, the terms "mount", "connect", and "connection" are to be construed broadly. For instance, they may denote fixed connection, detachable connection or integral connection, denote mechanical connection, electric connection or mutual communication, denote direct connection or indirect connection through an intermediate medium, or denote communication between interiors of two elements or interaction between two elements. Specific meanings of the above terms in the present disclosure may be understood in accordance with specific conditions for those of ordinary skill in the art.

In the present disclosure, unless otherwise specified and limited, a case of a first feature "on" or "under" a second feature may include direct contact between the first and second features, or may include a case that the first and second features are not in direct contact with each other and are in contact with each other through another feature therebetween. Moreover, a case of the first feature "on", "above" and "at an upper portion of" the second feature includes a case that the first feature is directly above and obliquely above the second feature, or only indicates that a horizontal height of the first feature is greater than that of the second feature. A case of the first feature "under", "below" and "at a lower portion of" the second feature includes a case that the first feature is directly below and obliquely below the second feature, or only indicates that a horizontal height of the first feature is less than that of the second feature.

Many different examples or instances will be disclosed below so as to implement different structures of the present disclosure. In order to simplify the present disclosure, components and arrangements of specific instances will be described below. Clearly, the instances are only illustrative and are not intended to limit the present disclosure. In addition, at least one of reference numerals and reference letters may be repeated in different instances of the present disclosure for purposes of simplicity and clarity, and does not indicate relationships of at least one of the examples and arrangements discussed. In addition, the present disclosure provides instances of various specific processes and materials. However, those of ordinary skill in the art may be aware of at least one of application of other processes and use scenes of other materials.

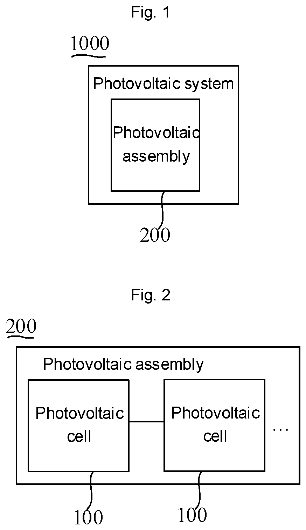

With reference to Fig. 1 to Fig. 2, a photovoltaic system 1000 of an example of the present disclosure may include a cell assembly 200 of an example of the present disclosure. The cell assembly 200 of the example of the present disclosure may include a plurality of back contact solar cells 100 of an example of the present disclosure.

The plurality of back contact solar cells 100 in the cell assembly 200 may be connected in series to form a plurality of cell strings. All the cell strings may be connected in series to implement confluent output of currents, all the cell strings may be connected in parallel to implement confluent output of currents, or all the cell strings may be combined in a series-parallel connection manner to implement confluent output of currents. For instance, connection between all the cells in the cell strings may be implemented through welding of welding strips, and connection between all the cell strings may be implemented through a bus bar. In some examples, all the cell strings may form a cell array, and then the cell assembly 200 is formed by packaging the cell array through a front sheet, a front encapsulant film, a rear encapsulant film, and a back sheet.

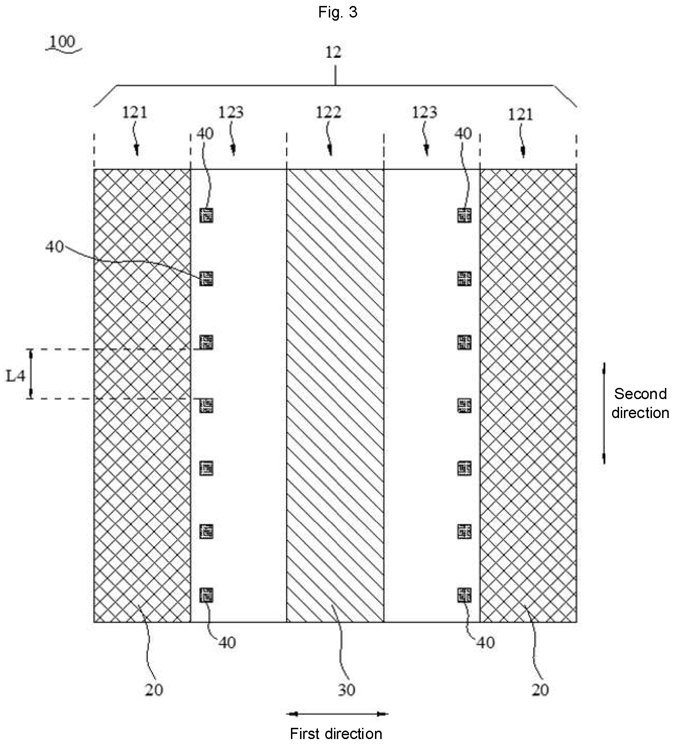

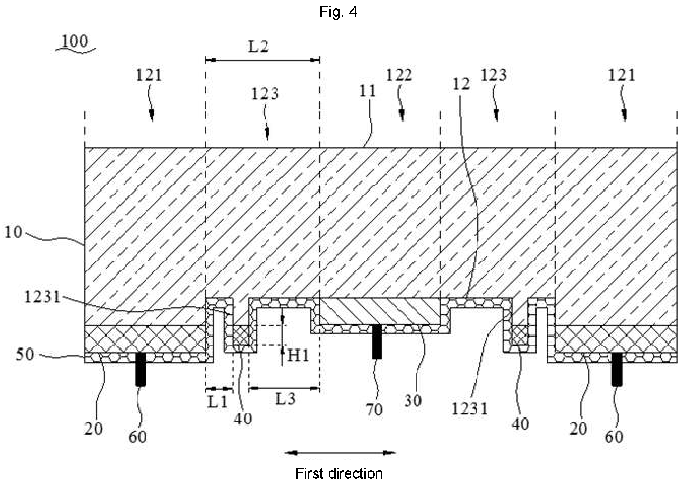

With reference to Fig. 3 and Fig. 4, the back contact solar cell 100 of the example of the present disclosure may include a silicon wafer 10, a plurality of first polarity doped layers 20, a plurality of second polarity doped layers 30, and a plurality of first isolated doped parts 40.

The silicon wafer 10 has a front surface 11 (i.e. a light-receiving surface) and a back surface 12 (i.e. a non-light-receiving surface) opposite each other. The back surface 12 of the silicon wafer 10 includes first zones 121 and second zones 122 that are alternately and sequentially configured in a first direction in a spaced manner. The first zones 121 and the second zones 122 extend in a second direction. Spacing zones 123 are provided between the adjacent first zones 121 and second zones 122. The second direction intersects with the first direction. That is, the first zones 121 are spaced from the second zones 122 by the spacing zones 123, and the spacing zones 123 further extend in the second direction.

Specifically, as shown in Fig. 3, the first zones 121 and the second zones 122 may be alternately configured in a transverse direction of the silicon wafer 10 and extend in a longitudinal direction. That is, the first direction may be the transverse direction of the back contact solar cell 100, the second direction may be the longitudinal direction of the back contact solar cell 100, and the first direction is perpendicular to the second direction. Clearly, in other examples, the first direction and the second direction may be other directions. For instance, the first direction and the second direction may be diagonal directions of the silicon wafer 10, respectively, and are not specifically limited herein.

In the example of the present disclosure, the first polarity doped layers 20 are stacked on the first zones 121, and the second polarity doped layers 30 are stacked on the second zones 122. Polarities of the first polarity doped layers 20 are different from polarities of the second polarity doped layers 30. That is, the first polarity doped layers have different doping types from the second polarity doped layers. The first polarity doped layer 20 is stacked on each first zone 121, and the second polarity doped layer 30 is stacked on each second zone 122. The first polarity doped layers 20 are spaced from the second polarity doped layers 30 by the spacing zones 123.

As shown in Fig. 3 and Fig. 4, the plurality of first isolated doped parts 40 are independently arranged in the spacing zones 123 (that is, the plurality of first isolated doped parts 40 are arranged in the spacing zones 123 in a spaced manner), and the first isolated doped parts 40 are spaced from the first polarity doped layers 20 and the second polarity doped layers 30. That is, the plurality of first isolated doped parts 40 may be arranged in the spacing zones 123 in a spaced manner, the first isolated doped parts 40 are not in contact with the first polarity doped layers 20 and the second polarity doped layers 30, and all the first isolated doped parts 40 are isolated doped points.

It should be noted that a case that a film layer is stacked on a zone or a film layer herein may indicate that the film layer is directly stacked on a surface zone or a film layer, or another film layer is arranged between the film layer and a surface zone or a film layer, and stacking arrangement only indicates a stacking arrangement mode for defining the film layer. For instance, in some examples, in the back contact solar cell 100, tunneling layers (not shown in the figure) may be further provided between the first polarity doped layers 20 and the silicon wafer 10, and tunneling layers may be provided between the second polarity doped layers 30 and the silicon wafer 10. The tunneling layers include, but are not limited to, tunneling oxidation layers (for instance, silicon dioxide tunneling layers), intrinsic amorphous silicon layers, and other film layers. For instance, in some examples, tunneling layers (for instance, silicon dioxide tunneling layers) may be provided between the first isolated doped parts 40 and surfaces of the spacing zones 123.

In addition, a case that two structures or film layers herein indicates that the two structures or film layers are independent of each other and not in contact with each other. For instance, a case that the first isolated doped parts 40 are spaced from the first polarity doped layers 20 and the second polarity doped layers 30 indicates that the first isolated doped parts 40 are not in contact with the first polarity doped layers 20 and the second polarity doped layers 30. Reference may be made to the understanding in a case of similar description below.

In the back contact solar cell 100, the cell assembly 200, and the photovoltaic system 1000 according to the examples of the present disclosure, the back surface 12 of the silicon wafer 10 is provided with the first zones 121 and the second zones 122 that are alternately configured in a spaced manner, the first zones 121 are spaced from the second zones 122 by the spacing zones 123, the first polarity doped layers 20 are stacked on the first zones 121, the second polarity doped layers 30 are stacked on the second zones 122, and the second polarity doped layers 30 are spaced from the first polarity doped layers 20 by the spacing zones 123. The plurality of first isolated doped parts 40 independent of the first polarity doped layers 20 and the second polarity doped layers 30 are arranged in the spacing zones 123. The first isolated doped parts 40 are not in contact with the first polarity doped layers 20 and the second polarity doped layers 30. In this way, electrical isolation between the first polarity doped layers 20 and the second polarity doped layers 30 can be ensured through the arrangement of the spacing zones 123, and short circuit can be avoided. Moreover, the plurality of independent first isolated doped parts 40 are arranged in the spacing zones 123, and the first isolated doped parts 40 may form floating junction passivation in the spacing zones 123, such that a passivation effect of the spacing zones 123 can be improved, and a probability of surface recombination at the spacing zones 123 can be further reduced. Thus, a collection rate of carriers (that is, a probability that photon-generated carriers are collected and participate in current flow) is improved, and efficiency of the back contact solar cell 100 is improved. That is, in the example of the present disclosure, through the arrangement of the first isolated doped parts 40, a better passivation effect can be achieved in a case of ensuring an isolation effect of the first polarity doped layers 20 and the second polarity doped layers 30, a probability of surface recombination at the spacing zones 123 is reduced, and efficiency of the back contact solar cell 100 is improved.

Specifically, in the example of the present disclosure, the silicon wafer 10 may be an N-type silicon wafer or a P-type silicon wafer, and is not specifically limited herein. The polarities of the first polarity doped layers 20 are different from the polarities of the second polarity doped layers 30. If one of the first polarity doped layer 20 and the second polarity doped layer 20 is a P-type doped layer, the other one is an N-type doped layer. When the first polarity doped layers 20 are P-type doped layers and collect holes, the second polarity doped layers 30 are N-type doped layers and collect electrons. When the first polarity doped layers 20 are N-type doped layers and collect electrons, the second polarity doped layers 30 are P-type doped layers and collect holes. Specific limitations are not provided herein, as long as the first polarity doped layers and the second polarity doped layers have different polarities.

In some examples, if the first polarity doped layers 20 may be P-type doped layers, the second polarity doped layers 30 may be N-type doped layers and the first isolated doped parts 40 may be P-type doped parts. In this case, when the back contact solar cell 100 works, the first polarity doped layers 20 collect holes and the second polarity doped layers 30 collect electrons, and the holes and the electrons are easily surface-recombined at the spacing zones 123. However, the P-type first isolated doped parts 40 are arranged at the spacing zones 123, and floating junction passivation may be formed at the first isolated doped parts 40, such that a passivation effect is improved. Meanwhile, the holes may be saturated in the first isolated doped parts 40, and then the zones may repel the holes, thus reducing a probability of surface recombination of the holes in the spacing zones 123. In this way, the holes can be quickly and efficiently collected by the first polarity doped layers 20, such that a collection rate of hole carriers is improved, and further conversion efficiency of the back contact solar cell 100 is improved.

In some examples, if the first polarity doped layers 20 may be N-type doped layers, the second polarity doped layers 30 may be P-type doped layers and the first isolated doped parts 40 may be N-type doped parts. In this case, when the back contact solar cell 100 works, the first polarity doped layers 20 collect electrons and the second polarity doped layers 30 collect holes, and the holes and the electrons are easily surface-recombined at the spacing zones 123. However, the N-type first isolated doped parts 40 are arranged at the spacing zones 123, and floating junction passivation may be formed at the first isolated doped parts 40, such that a passivation effect is improved. Meanwhile, the electrons may be saturated in the first isolated doped parts 40, and then the zones may repel the electrons, thus reducing a probability of recombination of the electrons in the spacing zones 123. That is, large surface recombination of the electrons and the holes at the spacing zones 123 is effectively avoided. In this way, the electrons can be quickly and efficiently collected by the first polarity doped layers 20, such that a collection rate of electron carriers is improved, and further conversion efficiency of the back contact solar cell 100 is improved.

It may be understood that surface recombination is a continuous loss. Without the first isolated doped parts 40 in the spacing zones 123, continuous surface recombination may occur in the spacing zones 123. In the present disclosure, through the arrangement of the first isolated doped parts 40, carriers (holes or electrons) at the first isolated doped parts 40 may quickly achieve filling saturation. After saturation, the carriers are repelled at the positions, and a probability of surface recombination is reduced, thus improving a collection rate of carriers and further improving efficiency.

In addition, as shown in Fig. 4, in the back contact solar cell 100 of the present disclosure, the back surface 12 is further provided with a back passivation film layer 50, and the back passivation film layer 50 covers the first polarity doped layers 20, the second polarity doped layers 30, and the spacing zones 123. That is, the back passivation film layer 50 may cover the entire back surface 12.

First electrodes 60 and second electrodes 70 are arranged on the back passivation film layer 50. The first electrodes 60 are arranged on the back passivation film layer 50 and located in the first zones 121, and the first electrodes 60 are conductively connected to the first polarity doped layers 20. For instance, in some examples, the first electrodes 60 may penetrate through the back passivation film layer 50 to be in conductive contact with the first polarity doped layers 20.

The second electrodes 70 are arranged on the back passivation film layer 50 and located in the second zones 122, and the second electrodes 70 are conductively connected to the second polarity doped layers 30. For instance, in some examples, the second electrodes 70 may penetrate through the back passivation film layer 50 to be in conductive contact with the second polarity doped layers 30. No electrodes are provided on the first isolated doped parts 40. That is, the first electrodes 60 and the second electrodes 70 are physically spaced from and not in contact with the first isolated doped parts 40, so as to avoid the situation that carriers cannot achieve saturation at the first isolated doped parts 40.

In the example of the present disclosure, a specific shape of the first isolated doped parts 40 may be a regular shape or an irregular shape. For instance, in some examples, a shape of the first isolated doped parts 40 may be one or more of a square, a cone, a pyramid, a frustum, and a circular truncated cone, and is not specifically limited herein.

With reference to Fig. 4, in some examples, in the first direction, a distance L1 between the first isolated doped parts 40 and the first polarity doped layers 20 is greater than or equal to 300 nm.

In this way, a poor isolation effect between the first isolated doped parts 40 and the first polarity doped layers 20 due to too small a distance between the first isolated doped parts 40 and the first polarity doped layers 20 can be avoided. That is, the arrangement can improve the isolation effect between the first isolated doped parts 40 and the first polarity doped layers 20, such that a collection rate of carriers can reach a better state, and meanwhile, a passivation effect of the spacing zones 123 can be improved.

Specifically, it is not difficult to understand that in a case that the distance L1 therebetween is too small (that is, less than 300 nm), an electrical isolation effect between the first isolated doped parts 40 and the first polarity doped layers 20 is poor, that is, connection between the first isolated doped parts 40 and the first polarity doped layers 20 easily leads to the situation that carriers at the first isolated doped parts 40 are directly collected by the first polarity doped layers 20, the corresponding carriers cannot be saturated at the first isolated doped parts 40, a function of repelling holes or electrons at the first isolated doped parts 40 cannot be achieved, and an effect of reducing surface recombination is obviously decreased.

That is, in the present disclosure, the distance L1 between the first isolated doped parts 40 and the first polarity doped layers 20 is set to be greater than or equal to 300 nm, such that surface recombination of the spacing zones 123 can be significantly reduced, and a collection rate of carriers can reach a better state.

Specifically, in such an example, the distance L1 between the first isolated doped parts 40 and the first polarity doped layers 20 may be, for instance, any value of 300 nm, 400 nm, 500 nm, 600 nm, 700 nm, 800 nm, 900 nm, 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, etc.

As shown in Fig. 4, in the example of the present disclosure, a width L2 of the spacing zones 123 in the first direction may be 50 µm to 300 µm. The maximum distance between the first isolated doped parts 40 and the first polarity doped layers 20 may preferably be a width L2 of the spacing zones 123 in the first direction minus 6 µm, that is, 300 nm≤L1≤L2-6 µm. Through research, it is found that L1 is most preferably greater than or equal to 3 µm and less than or equal to L2-6 µm. In this case, performance of the back contact solar cell 100 may be optimized.

With reference to Fig. 4, in some examples, in the first direction, a distance L3 between the first isolated doped parts 40 and the second polarity doped layers 30 may be greater than or equal to 300 nm.

In this way, the distance L3 between the first isolated doped parts 40 and the second polarity doped layers 30 is set to be greater than 300 nm, thus ensuring an isolation effect of the first isolated doped parts 40 and the second polarity doped layers 30. The situation that some carriers at the first isolated doped parts 40 are directly recombined with carriers at the second polarity doped layers 30, the carriers of the first isolated doped parts 40 cannot achieve saturation, and an effect of reducing surface recombination is obviously decreased.

Specifically, it is not difficult to understand that in a case that the distance therebetween is too small (that is, less than 300 nm), connection between the first isolated doped parts 40 and the second polarity doped layers 30 easily leads to the situation that carriers (for instance, holes) at the first isolated doped parts 40 are directly recombined with the carriers (for instance, electrons) of the second polarity doped layers 30, the corresponding carriers (for instance, holes) cannot be saturated at the first isolated doped parts 40, a function of repelling holes or electrons at the first isolated doped parts 40 cannot be achieved, and an effect of reducing surface recombination is obviously decreased.

That is, in the present disclosure, the distance L3 between the first isolated doped parts 40 and the second polarity doped layers 30 is set to be greater than or equal to 300 m, such that surface recombination of the spacing zones 123 can be significantly reduced, and a collection rate of carriers can reach a better state.

Specifically, in such an example, the distance L3 between the first isolated doped parts 40 and the second polarity doped layers 30 may be, for instance, any value of 300 nm, 400 nm, 500 nm, 600 nm, 700 nm, 800 nm, 900 nm, 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, etc. The maximum distance between the first isolated doped parts 40 and the second polarity doped layers 30 may preferably be a width of the spacing zones 123 in the first direction minus 6 µm, that is, 300 nm≤L3≤L2-6 µm. Through research, it is found that L3 is most preferably greater than or equal to 3 µm and less than or equal to L2-6 µm. In this case, performance of the back contact solar cell 100 may be optimized.

In the example of the present disclosure, preferably, the distance between the first isolated doped parts 40 and the first polarity doped layers 20 is greater than or equal to 3 µm and less than the width of the spacing zones 123 minus 6 µm, and the distance between the first isolated doped parts 40 and the second polarity doped layers 30 is greater than or equal to 3 µm and less than the width of the spacing zones 123 minus 6 µm, such that surface recombination of the spacing zones 123 can be greatly reduced, and a collection rate of the carriers can reach an optimal state.

In some examples, the plurality of first isolated doped parts 40 may be randomly distributed on the spacing zones 123, or the plurality of first isolated doped parts 40 may be arranged on the spacing zones 123 in the second direction in a spaced manner, which is not specifically limited herein.

When the plurality of first isolated doped parts 40 are randomly distributed on the spacing zones 123, the distance between any two first isolated doped parts 40 (i.e. a length of a connecting line between any two first isolated doped parts 40) is 30 µm to 380 µm.

With reference to Fig. 3, in some examples, if the plurality of first isolated doped parts 40 are arranged on the spacing zones 123 in the second direction in a spaced manner, a distance L4 between two adjacent the first isolated doped parts 40 may be 30 µm to 380 µm.

In this way, the situation that the distance between the first isolated doped parts 40 is too small so as to cause the first isolated doped parts 40 to be too dense can be avoided.

Specifically, when the plurality of first isolated doped parts 40 are randomly distributed on the spacing zones 123, the distance between any two first isolated doped parts 40 may be, for instance, 30 µm, 35 µm, 40 µm, 45 µm, 50 µm, 55 µm, 60 µm, 65 µm, 70 µm, 75 µm, 80 µm, 85 µm, 90 µm, 95 µm, 100 µm, 120 µm, 140 µm, 160 µm, 180 µm, 200 µm, 220 µm, 240 µm, 260 µm, 280 µm, 300 µm, 320 µm, 340 µm, 360 µm, 380 µm, or any value of 30 µm to 380 µm.

When the plurality of first isolated doped parts 40 may be arranged on the spacing zones 123 in the second direction in a spaced manner, the distance L4 between two adjacent the first isolated doped parts 40 may be, for instance, 30 µm, 35 µm, 40 µm, 45 µm, 50 µm, 55 µm, 60 µm, 65 µm, 70 µm, 75 µm, 80 µm, 85 µm, 90 µm, 95 µm, 100 µm, 120 µm, 140 µm, 160 µm, 180 µm, 200 µm, 220 µm, 240 µm, 260 µm, 280 µm, 300 µm, 320 µm, 340 µm, 360 µm, 380 µm, or any value of 30 µm to 380 µm.

With reference to Fig. 4, in some examples, a thickness H1 of the first isolated doped parts 40 may be 20 nm to 450 nm.

In this way, the thickness of the first isolated doped parts 40 is set within the range, such that the situation that the thickness of the first isolated doped parts 40 is too small to achieve an efficient floating junction passivation effect can be avoided, and further an increase in cost due to too great a thickness of the first isolated doped parts 40 can be avoided.

Specifically, the thickness H1 of the first isolated doped parts 40 may be, for instance, 20 nm, 22 nm, 24 nm, 26 nm, 28 nm, 30 nm, 32 nm, 34 nm, 36 nm, 38 nm, 40 nm, 42 nm, 44 nm, 46 nm, 48 nm, 50 nm, 100 nm, 150 nm, 200 nm, 250 nm, 300 nm, 350 nm, 400 nm, 450 nm, or any value of 20 nm to 450 nm.

In some examples, a ratio of an orthographic projection area of all the first isolated doped parts 40 in the single spacing zone 123 in a thickness direction of the silicon wafer 10 to an orthographic projection area of the single spacing zone 123 in the thickness direction of the silicon wafer 10 is 0.0001 to 0.5.

In this way, the situation that an expected effect cannot be achieved because an area of a floating junction passivation zone is too small due to too small an area ratio of the first isolated doped parts 40 can be avoided, a reduction in carriers collected by the first polarity doped layers 20 due to too many carriers saturated at the first isolated doped parts 40 because of too great an area ratio of the first isolated doped parts 40 can be avoided, and meanwhile, a sharp decline in bifacial ratio caused by serious parasitic absorption of light of the back surface due to too great an area ratio of the first isolated doped parts 40 can be avoided.

That is, in such an example, if the area ratio of the first isolated doped parts to the single spacing zone is set within the rational range, a quantity of collected carriers can be ensured while a collection rate of carriers can be improved. Through such an optimized design, a relationship between the collection rate and a collection quantity of the carriers can be balanced, thus optimizing conversion efficiency of the back contact solar cell 100.

In such an example, the area ratio of the first isolated doped parts to the single spacing zone may preferably be 0.001 to 0.1. In this way, through the optimized design, a relationship between the bifacial ratio and efficiency can be balanced, and the back contact solar cell 100 can achieve a better bifacial ratio while conversion efficiency of the back contact solar cell 100 can be improved.

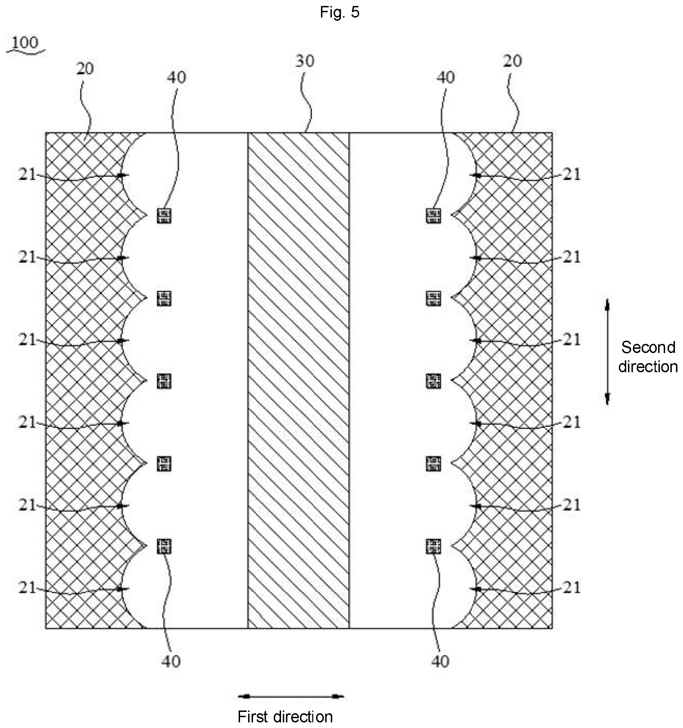

With reference to Fig. 5, in some examples, a plurality of first arc-shaped concave zones 21 are formed on side wall surfaces of the first polarity doped layers 20 adjacent to the spacing zones 123, the plurality of first arc-shaped concave zones 21 are configured in the second direction, two adjacent the first arc-shaped concave zones 21 intersect with each other, and the first isolated doped part 40 is arranged near a junction of the two adjacent the first arc-shaped concave zones 21.

In this way, the arrangement of the first arc-shaped concave zones 21 is conducive to reduction in carrier recombination rate of the first polarity doped layers 20 near the spacing zones 123 and improvement in collection rate of the carriers. In addition, a manufacturing process of the first arc-shaped concave zones 21 is simple, and damage to the first polarity doped layers 20 is small, which is conducive to subsequent deposition of the back passivation film layer 50, thus improving passivation performance of the back contact solar cell 100. In addition, a field passivation effect can be further improved by arranging the first isolated doped part 40 near the junction of the two first arc-shaped concave zones 21.

Specifically, in the example, a shape of the first arc-shaped concave zones 21 may be a regular arc, such as an arc, or an irregular arc with different curvatures at different positions, which is not specifically limited herein. The case that the two adjacent the first arc-shaped concave zones 21 intersect with each other means that the side wall surfaces of the first polarity doped layers 20 adjacent to the spacing zones 123 are composed of the plurality of first arc-shaped concave zones 21, that is, a contour of the side wall surfaces of the first polarity doped layers 20 adjacent to the spacing zones 123 is basically a wave-shaped curve.

In such an example, a distance between the first isolated doped part 40 and an intersection point of the two adjacent the first arc-shaped concave zones 21 is greater than or equal to 300 nm.

With reference to Fig. 4, in some examples, in the spacing zones 123, the silicon wafer 10 is provided with first isolated protrusions 1231, and the first isolated doped parts 40 are arranged on the first isolated protrusions 1231 and cover at least partial zones of the first isolated protrusions 1231. In this way, a subsequent passivation effect of the back passivation film layer 50 can be improved through the arrangement of the first isolated protrusions 1231.

Specifically, in such an example, in the example of the present disclosure, the spacing zones 123 and the second zones 122 are recessed further into the silicon wafer 10 than the first zones 121, and surfaces of the first isolated protrusions 1231 may be flush with surfaces of the stacked first polarity doped layers 20.

In one possible example, in a manufacturing process, the first polarity doped layers 20 may be deposited on the entire back surface 12 of the silicon wafer 10, and then the first polarity doped layers 20 in some zones may be removed through etching (laser etching, wet etching, etc.), such that the plurality of first polarity doped layers 20 arranged in the first direction are formed, and some independent first isolated doped parts 40 are left. It may be understood that in a removal process, recesses may be formed on the silicon wafer 10, and the first isolated protrusions 1231 protruding relative to the recesses may be formed below the first isolated doped parts 40. Then, the second polarity doped layers 30 may be manufactured in the recesses, and the second polarity doped layers 30 are spaced from the first polarity doped layers 20. In this way, zones corresponding to the first polarity doped layers 20 are the first zones 121, zones corresponding to the second polarity doped layers 30 are the second zones 122, and zones between zones where the first polarity doped layers 20 are located and zones where the second polarity doped layers 30 are located are the spacing zones 123. The silicon wafer 10 is provided with the first isolated protrusions 1231 in the spacing zones 123, and the first isolated doped parts 40 are arranged on the first isolated protrusions 1231. Clearly, it may be understood that in other examples, the back contact solar cell 100 may be manufactured in another mode, which is not specifically limited herein, as long as a structure corresponding to the present disclosure can be formed.

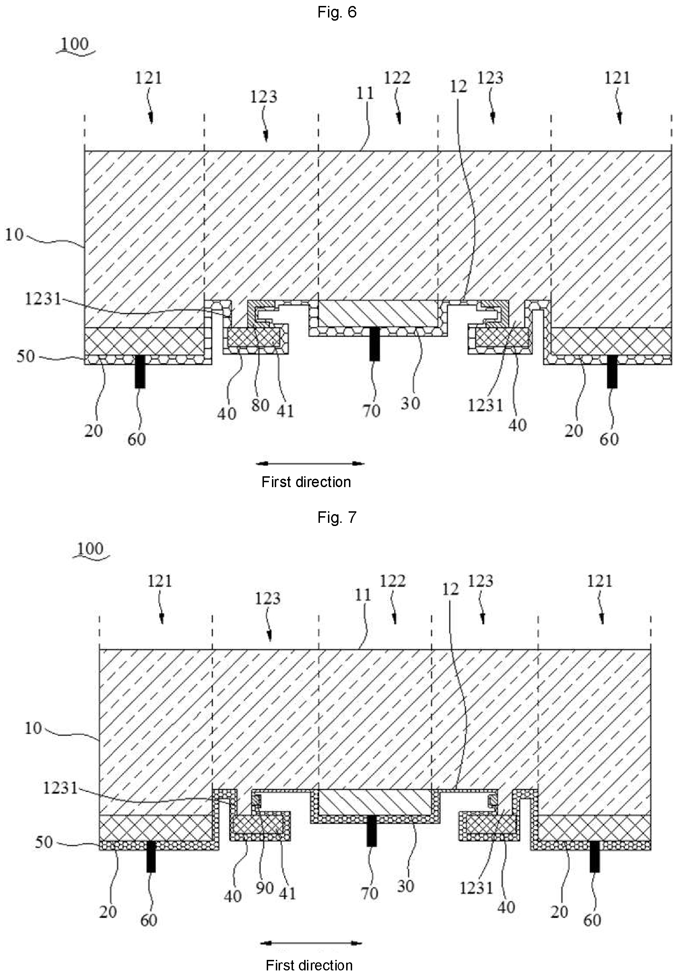

With reference to Fig. 6, in some examples, the first isolated doped parts 40 completely cover the first isolated protrusions 1231, and the first isolated doped parts 40 have first suspended sections 41 extending out of the first isolated protrusions 1231 and suspended in the spacing zones 123.

In this way, the first isolated doped parts 40 have the first suspended sections 41 extending and suspended above the spacing zones 123, and spaced and opposite deposition zones are configured between the first suspended sections 41 and the silicon wafer 10. In a subsequent deposition process of the back passivation film layer 50, the arrangement of the deposition zones may inhibit full exchange of plasma components in the zones and those outside the zones, thus implementing localized distribution of movable hydrogen contents of the back passivation film layer 50 on the back surface 12. In this way, the movable hydrogen contents of the back passivation film layer 50 in the deposition zones are smaller, and the movable hydrogen contents of the back passivation film layer 50 in other zones are greater, such that optimal passivation and attenuation resistance effects are achieved. Meanwhile, direct bombardment of plasma on the silicon wafer and bombardment damage can be reduced.

Specifically, in such an example, the first suspended sections 41 may extend in any direction and be suspended above the spacing zones 123. Specifically, an extension direction of the first suspended sections 41 is not limited.

An extension length of the first suspended sections 41 relative to the first isolated protrusions 1231 may be 0.2 µm to 50 µm, and for instance, 0.2 µm, 0.4 µm, 0.6 µm, 0.8 µm, 1 µm, 2 µm, 3 µm, 4 µm, 5 µm, 6 µm, 7 µm, 8 µm, 9 µm, 10 µm, 20 µm, 30 µm, 40 µm, 50 µm, or any value of 0.2 µm to 50 µm.

With reference to Fig. 6, in some examples, surfaces of the first suspended sections 41 facing the silicon wafer 10 are provided with second isolated doped parts 80, and polarities of the second isolated doped parts 80 are different from the polarities of the first polarity doped layers 20 and are the same as the polarities of the second polarity doped layers 30. The second isolated doped parts 80 are spaced from and are not in contact with the first polarity doped layers 20 and the second polarity doped layers 30.

In this way, the second isolated doped parts 80 having different polarities are arranged on the surfaces of the first suspended sections 41 facing the silicon wafer 10, such that a passivation effect on the first suspended sections 41 can be improved, and a passivation effect on the entire spacing zones 123 can be further improved.

Specifically, in such an example, the second isolated doped parts 80 located on the first suspended sections 41 may be an integrated and continuous single doped part, or the plurality of independent second isolated doped parts 80 are provided on the first suspended sections 41. In such an example, the second isolated doped parts 80 may be in direct contact with the first suspended sections 41 or be insulated from the first suspended sections 41.

Further, with reference to Fig. 6, in some examples, the second isolated doped parts 80 further extend along side surfaces of the first isolated protrusions 1231 to zones, shielded by the first suspended sections 41, of the silicon wafer 10.

In this way, the arrangement of the second isolated doped parts 80 can further improve a passivation effect on the side surfaces of the first isolated protrusions 1231 and the zones shielded by the first suspended sections 41, and further improve a passivation effect at the spacing zones 123.

With reference to Fig. 7, in some examples, the side surfaces of the first isolated protrusions 1231 are provided with third isolated doped parts 90, and the third isolated doped parts 90 are spaced from the first isolated doped parts 40 (that is, the third isolated doped parts 90 are not in contact with the first isolated doped parts 40), so as to improve a passivation effect of the first isolated protrusions 1231.

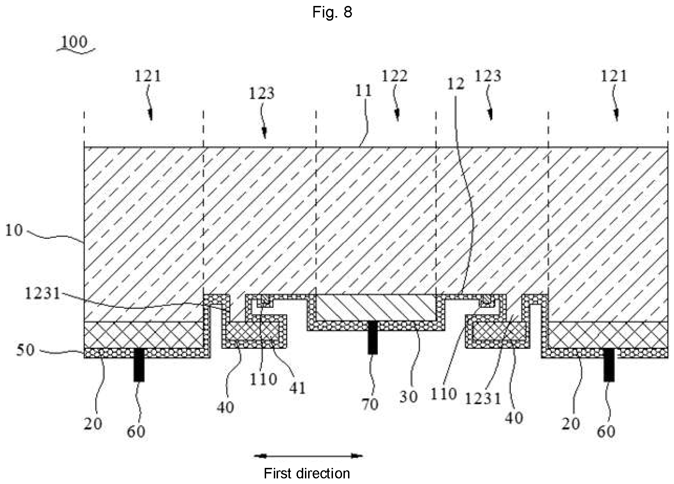

With reference to Fig. 8, in some examples, the zones, shielded by the first suspended sections 41, of the silicon wafer 10 are provided with fourth isolated doped parts 110, polarities of the fourth isolated doped parts 110 are the same as the polarities of the second polarity doped layers 30, and the fourth isolated doped parts 110 are spaced from the first polarity doped layers 20 and the second polarity doped layers 30. That is, the fourth isolated doped parts 110 are not in contact with the first polarity doped layers 20 and the second polarity doped layers 30.

In this way, the fourth isolated doped parts 110 are in contact with the silicon wafer 10 and are not in contact with the first polarity doped layers 20 and the second polarity doped layers 30, such that the fourth isolated doped parts 110 having different polarities are arranged while the first isolated doped parts 40 are arranged, and the first isolated doped parts 40 and the fourth isolated doped parts 110 may form field passivation in the spacing zones 123. Thus, a passivation effect is improved. Moreover, the arrangement of the first isolated doped parts 40 and the fourth isolated doped parts 110 can improve a collection rate of holes and electrons.

Specifically, when a doping type of the first isolated doped parts 40 is P-type doping and a doping type of the fourth isolated doped parts 110 is N-type doping, hole carriers are saturated at the first isolated doped parts 40, which may generate a repulsive force to subsequent hole carriers, such that the hole carriers can be collected by the first polarity doped layers 20 more quickly. Electron carriers are saturated at the fourth isolated doped parts 110, which may generate a repulsive force to subsequent electrons, such that the electrons can be collected by the second polarity doped layers 30 more quickly. In this way, a probability of recombination of holes and electrons in the spacing zones 123 is reduced, thus improving a collection rate of the carriers and further improving efficiency of the back contact solar cell 100.

Similarly, when a doping type of the first isolated doped parts 40 is N-type doping and a doping type of the fourth isolated doped parts 110 is P-type doping, electron carriers are saturated at the first isolated doped parts 40, which may generate a repulsive force to subsequent electron carriers, such that the electron carriers can be collected by the first polarity doped layers 20 more quickly. Hole carriers are saturated at the fourth isolated doped parts 110, which may generate a repulsive force to subsequent holes, such that the holes can be collected by the second polarity doped layers 30 more quickly. In this way, large recombination of holes and electrons in the spacing zones 123 is avoided, thus improving a collection rate of the carriers and further improving efficiency of the back contact solar cell 100.

That is, the arrangement of the first isolated doped parts 40 and the fourth isolated doped parts 110 can improve a collection rate of holes and electrons at the spacing zones 123, thus improving efficiency of the back contact solar cell 100.

Further, in such an example, the fourth isolated doped parts 110 are preferably spaced from the first isolated protrusions 1231 and the first isolated doped parts 40. That is, the fourth isolated doped parts 110 are not in contact with the first isolated protrusions 1231. In this way, the fourth isolated doped parts 110 are arranged to be not in contact with the first isolated protrusions 1231 and the first isolated doped parts 40, such that a collection rate of holes and electrons can be further improved, and efficiency of the back contact solar cell 100 can be further improved.

With reference to Fig. 8, in some examples, in the first direction, a distance between the fourth isolated doped parts 110 and the first isolated protrusions 1231 is 0.1 µm to 200 µm.

In this way, the distance between the fourth isolated doped parts 110 and the first isolated protrusions 1231 is set as 0.1 µm to 200 µm, such that a collection rate of carriers can be further optimized, and surface recombination can be further reduced.

Specifically, in such an example, the distance between the fourth isolated doped parts 110 and the first isolated protrusions 1231 may be, for instance, 0.1 µm, 0.2 µm, 0.4 µm, 0.6 µm, 0.8 µm, 1 µm, 2 µm, 3 µm, 4 µm, 5 µm, 6 µm, 7 µm, 8 µm, 9 µm, 10 µm, 20 µm, 30 µm, 40 µm, 50 µm, 60 µm, 70 µm, 80 µm, 90 µm, 100 µm, 120 µm, 140 µm, 160 µm, 180 µm, 200 µm, or any value of 0.1 µm to 200 µm.

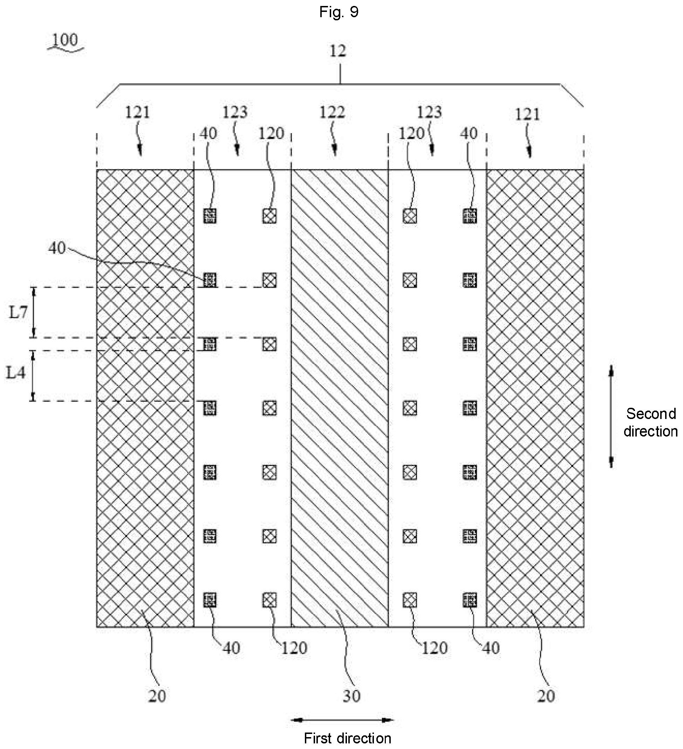

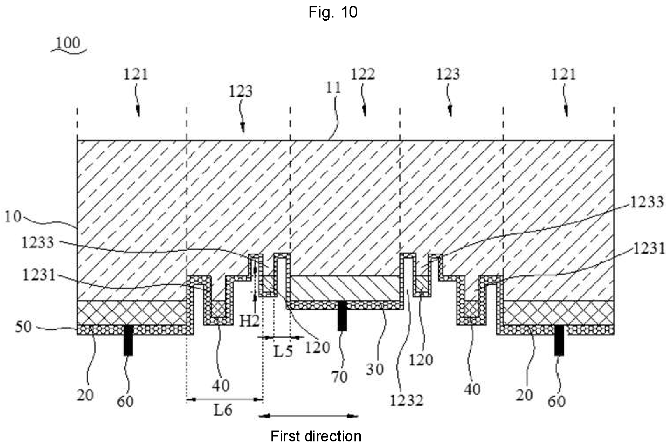

With reference to Fig. 9 and Fig. 10, in some examples, the back contact solar cell 100 includes a plurality of fifth isolated doped parts 120. The plurality of fifth isolated doped parts 120 are arranged in the spacing zones 123. The fifth isolated doped parts 120 are spaced from the first polarity doped layers 20 and the second polarity doped layers 30. Polarities of the fifth isolated doped parts 120 are the same as the polarities of the second polarity doped layers 30.

In this way, the plurality of first isolated doped parts 40 and fifth isolated doped parts having different polarities are simultaneously arranged in the spacing zones 123, and the first isolated doped parts 40 and the fifth isolated doped parts 120 may form field passivation in the spacing zones 123, such that a passivation effect is enhanced, and a collection rate of holes and electrons is improved.

Specifically, when a doping type of the first isolated doped parts 40 is P-type doping and a doping type of the fifth isolated doped parts 120 is N-type doping, hole carriers are saturated at the first isolated doped parts 40, which may generate a repulsive force to subsequent hole carriers, such that the hole carriers can be collected by the first polarity doped layers 20 more quickly. Electron carriers are saturated at the fifth isolated doped parts 120, which may generate a repulsive force to subsequent electrons, such that the electrons can be collected by the second polarity doped layers 30 more quickly. In this way, a probability of recombination of holes and electrons in the spacing zones 123 is reduced, thus improving a collection rate of the carriers and further improving efficiency of the back contact solar cell 100.

Similarly, when a doping type of the first isolated doped parts 40 is N-type doping and a doping type of the fifth isolated doped parts 120 is P-type doping, electron carriers are saturated at the first isolated doped parts 40, which may generate a repulsive force to subsequent electron carriers, such that the electron carriers can be collected by the first polarity doped layers 20 more quickly. Hole carriers are saturated at the fifth isolated doped parts 120, which may generate a repulsive force to subsequent holes, such that the holes can be collected by the second polarity doped layers 30 more quickly. In this way, large recombination of holes and electrons in the spacing zones 123 is avoided, thus improving a collection rate of the carriers and further improving efficiency of the back contact solar cell 100.

That is, the arrangement of the first isolated doped parts 40 and the fifth isolated doped parts 120 can improve a collection rate of holes and electrons at the spacing zones 123, thus improving efficiency of the back contact solar cell 100.

In such an example, no electrodes are provided on the fifth isolated doped parts 120. That is, the first electrodes 60 and the second electrodes 70 are physically spaced from and not in contact with the fifth isolated doped parts 120.

In the example of the present disclosure, a specific shape of the fifth isolated doped parts 120 may be a regular shape or an irregular shape. For instance, in some examples, a shape of the first isolated doped parts 40 may be one or more of a cone, a pyramid, a frustum, and a circular truncated cone, and is not specifically limited herein.

Further, in such an example, the fifth isolated doped parts 120 are spaced from the first isolated doped parts 40 in the spacing zones 123. That is, the fifth isolated doped parts 120 are independent of and not in contact with the first isolated doped parts 40.

In this way, the fifth isolated doped parts 120 are arranged to be independent of and not in contact with the first isolated doped parts 40, such that a collection rate of holes and electrons can be further improved, and efficiency of the back contact solar cell 100 can be further improved.

Further, in some examples, a distance between any one of the fifth isolated doped parts 120 and any one of the first isolated doped parts 40 (i.e. a length of a connecting line between any one of the first isolated doped parts 40 and any one of the fifth isolated doped parts 120) is greater than or equal to 0.1 µm to 200 µm.

In this way, a distance between the fifth isolated doped parts 120 and the first isolated protrusions 1231 is set as 0.1 µm to 200 µm, such that a collection rate of carriers can be further optimized, and surface recombination can be further reduced.

Specifically, the distance between any one of the fifth isolated doped parts 120 and any one of the first isolated doped parts 40 may be any value of 0.1 µm to 200 µm, and for instance, one of 0.1 µm, 0.2 µm, 0.4 µm, 0.6 µm, 0.8 µm, 1 µm, 2 µm, 3 µm, 4 µm, 5 µm, 6 µm, 7 µm, 8 µm, 9 µm, 10 µm, 20 µm, 30 µm, 40 µm, 50 µm, 60 µm, 70 µm, 80 µm, 90 µm, 100 µm, 120 µm, 140 µm, 160 µm, 180 µm, and 200 µm.

With reference to Fig. 10, in some examples, in the first direction, a distance L5 between the fifth isolated doped parts 120 and the second polarity doped layers 30 is greater than or equal to 300 nm.

In this way, a poor isolation effect between the fifth isolated doped parts 120 and the second polarity doped layers 30 due to too small a distance between the fifth isolated doped parts 120 and the second polarity doped layers 30 can be avoided. That is, the arrangement can improve the isolation effect between the fifth isolated doped parts 120 and the second polarity doped layers 30, such that a collection rate of carriers can reach a better state, and meanwhile, a passivation effect of the spacing zones 123 can be improved.

Specifically, it is not difficult to understand that in a case that the distance therebetween is too small (that is, less than 300 nm), an electrical isolation effect between the fifth isolated doped parts 120 and the second polarity doped layers 30 is poor, that is, connection between the fifth isolated doped parts 120 and the second polarity doped layers 30 easily leads to the situation that carriers at the fifth isolated doped parts 120 are directly collected by the second polarity doped layers 30, the corresponding carriers cannot be saturated at the fifth isolated doped parts 120, a function of repelling holes or electrons at the fifth isolated doped parts 120 cannot be achieved, and an effect of reducing surface recombination is obviously decreased.

That is, in the present disclosure, the distance L5 between the fifth isolated doped parts 120 and the second polarity doped layers 30 is set to be greater than or equal to 300 nm, such that surface recombination of the spacing zones 123 can be significantly reduced, and a collection rate of carriers can reach a better state.

Specifically, in such an example, the distance L5 between the fifth isolated doped parts 120 and the second polarity doped layers 30 may be, for instance, any value of 300 nm, 400 nm, 500 nm, 600 nm, 700 nm, 800 nm, 900 nm, 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, etc.

The maximum distance between the fifth isolated doped parts 120 and the first polarity doped layers 20 may preferably be a width of the spacing zones 123 in the first direction minus 6 µm, that is, 300 nm≤L5≤L2-6 µm.

Through research, it is found that L5 is most preferably greater than or equal to 3 µm and less than or equal to L2-6 µm. In this case, performance of the back contact solar cell 100 may be optimized.

With reference to Fig. 10, in some examples, in the first direction, a distance L6 between the fifth isolated doped parts 120 and the first polarity doped layers 20 is greater than or equal to 300 nm.

In this way, the distance between the fifth isolated doped parts 120 and the first polarity doped layers 20 is set to be greater than 300 nm, thus ensuring an isolation effect of the fifth isolated doped parts 120 and the first polarity doped layers 20. The situation that some carriers at the fifth isolated doped parts 120 are directly recombined with carriers at the first polarity doped layers 20, the carriers of the fifth isolated doped parts 120 cannot achieve saturation, and an effect of reducing surface recombination is obviously decreased.

Specifically, it is not difficult to understand that in a case that the distance therebetween is too small (that is, less than 300 nm), connection between the fifth isolated doped parts 120 and the first polarity doped layers 20 easily leads to the situation that carriers (for instance, holes) at the fifth isolated doped parts 120 are directly recombined with the carriers (for instance, electrons) of the first polarity doped layers 20, the corresponding carriers (for instance, holes) cannot be saturated at the fifth isolated doped parts 120, a function of repelling holes or electrons at the fifth isolated doped parts 120 cannot be achieved, and an effect of reducing surface recombination is obviously decreased.

That is, in the present disclosure, the distance L6 between the fifth isolated doped parts 120 and the first polarity doped layers 20 is set to be greater than or equal to 300 nm, such that surface recombination of the spacing zones 123 can be significantly reduced, and a collection rate of carriers can reach a better state.

Specifically, in such an example, the distance L6 between the fifth isolated doped parts 120 and the first polarity doped layers 20 may be, for instance, any value of 300 nm, 400 nm, 500 nm, 600 nm, 700 nm, 800 nm, 900 nm, 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, etc. The maximum distance between the fifth isolated doped parts 120 and the first polarity doped layers 20 may preferably be a width of the spacing zones 123 in the first direction minus 6 µm, that is, 300 nm≤L6≤L2-6 µm. Through research, it is found that L6 is most preferably greater than or equal to 3 µm and less than or equal to L2-6 µm. In this case, performance of the back contact solar cell 100 may be optimized.

In the example of the present disclosure, preferably, the distance L1 between the fifth isolated doped parts 120 and the first polarity doped layers 20 is greater than or equal to 3 µm, and the distance L5 between the fifth isolated doped parts 120 and the second polarity doped layers 30 is greater than or equal to 3 µm, such that surface recombination of the spacing zones 123 can be greatly reduced, and a collection rate of the carriers can reach an optimal state.

In some examples, the plurality of fifth isolated doped parts 120 may be randomly distributed on the spacing zones 123, or the plurality of fifth isolated doped parts 120 may be arranged on the spacing zones 123 in the second direction in a spaced manner, which is not specifically limited herein.

When the plurality of fifth isolated doped parts 120 are randomly distributed on the spacing zones 123, the distance between any two fifth isolated doped parts 120 (i.e. a length of a connecting line between any two fifth isolated doped parts 120) is 30 µm to 380 µm.

With reference to Fig. 9, in some examples, if the plurality of fifth isolated doped parts 120 are arranged on the spacing zones 123 in the second direction in a spaced manner, a distance L7 between two adjacent the fifth isolated doped parts 120 may be 30 µm to 380 µm.

In this way, the situation that the distance between the fifth isolated doped parts 120 is too small so as to cause the fifth isolated doped parts 120 to be too dense can be avoided.

Specifically, when the plurality of fifth isolated doped parts 120 are randomly distributed on the spacing zones 123, the distance between any two fifth isolated doped parts 120 may be, for instance, any value of 30 µm to 380 µm. For instance, the distance between any two fifth isolated doped parts 120 may be one of 30 µm, 35 µm, 40 µm, 45 µm, 50 µm, 55 µm, 60 µm, 65 µm, 70 µm, 75 µm, 80 µm, 85 µm, 90 µm, 95 µm, 100 µm, 120 µm, 140 µm, 160 µm, 180 µm, 20 µm, 220 µm, 240 µm, 260 µm, 280 µm, 300 µm, 320 µm, 340 µm, 360 µm, and 380 µm.

When the plurality of fifth isolated doped parts 120 may be arranged on the spacing zones 123 in the second direction in a spaced manner, the distance L7 between the two adjacent fifth isolated doped parts 120 may be, for instance, any value of 30 µm to 380 µm. For instance, the distance L7 between the two adjacent fifth isolated doped parts 120 may be one of 30 µm, 35 µm, 40 µm, 45 µm, 50 µm, 55 µm, 60 µm, 65 µm, 70 µm, 75 µm, 80 µm, 85 µm, 90 µm, 95 µm, 100 µm, 120 µm, 140 µm, 160 µm, 180 µm, 200 µm, 220 µm, 240 µm, 260 µm, 280 µm, 300 µm, 320 µm, 340 µm, 360 µm, and 380 µm.

With reference to Fig. 10, in some examples, a thickness H2 of the fifth isolated doped parts 120 may be 20 nm to 450 nm.

In this way, the thickness of the fifth isolated doped parts 120 is set within the range, such that the situation that the thickness of the fifth isolated doped parts 120 is too small to achieve an efficient floating junction passivation effect can be avoided, and further an increase in cost due to too great a thickness of the fifth isolated doped parts 120 can be avoided.

Specifically, the thickness H2 of the fifth isolated doped parts 120 may be, for instance, any value of 20 nm to 450 nm. For instance, the thickness H2 of the fifth isolated doped parts 120 may be, for instance, one of 20 nm, 22 nm, 24 nm, 26 nm, 28 nm, 30 nm, 32 nm, 34 nm, 36 nm, 38 nm, 40 nm, 42 nm, 44 nm, 46 nm, 48 nm, 50 nm, 100 nm, 150 nm, 200 nm, 250 nm, 300 nm, 350 nm, 400 nm, and 450 nm.

In some examples, a ratio of an orthographic projection area of all the fifth isolated doped parts 120 in the single spacing zone 123 in a thickness direction of the silicon wafer 10 to an orthographic projection area of the single spacing zone 123 in the thickness direction of the silicon wafer 10 is 0.0001 to 0.5.

In this way, the situation that an expected effect cannot be achieved because an area of a floating junction passivation zone is too small due to too small an area ratio of the fifth isolated doped parts 120 can be avoided, a reduction in carriers collected by the first polarity doped layers 20 due to too many carriers saturated at the fifth isolated doped parts 120 because of too great an area ratio of the fifth isolated doped parts 120 can be avoided, and meanwhile, a sharp decline in bifacial ratio caused by serious parasitic absorption of light of the back surface due to too great an area ratio of the fifth isolated doped parts 120 can be avoided.

That is, in such an example, if the area ratio of the fifth isolated doped parts to the single spacing zone is set within the rational range, a quantity of collected carriers can be ensured while a collection rate of carriers can be improved. Through such an optimized design, a relationship between the collection rate and a collection quantity of the carriers can be balanced, thus optimizing conversion efficiency of the back contact solar cell 100.

Specifically, the ratio may be, for instance, one of 0.0001, 0.0005, 0.001, 0.0015, 0.002, 0.004, 0.006, 0.008, 0.01, 0.02, 0.03, 0.04, 0.05, 0.06, 0.07, 0.08, 0.09, 0.1, 0.15, 0.2, 0.25, 0.3, 0.35, 0.4, 0.45, and 0.5.

In such an example, the area ratio of the fifth isolated doped parts to the single spacing zone may preferably be 0.001 to 0.1. In this way, through the optimized design, a relationship between the bifacial ratio and efficiency can be balanced, and the back contact solar cell 100 can achieve a better bifacial ratio while conversion efficiency of the back contact solar cell 100 can be improved.

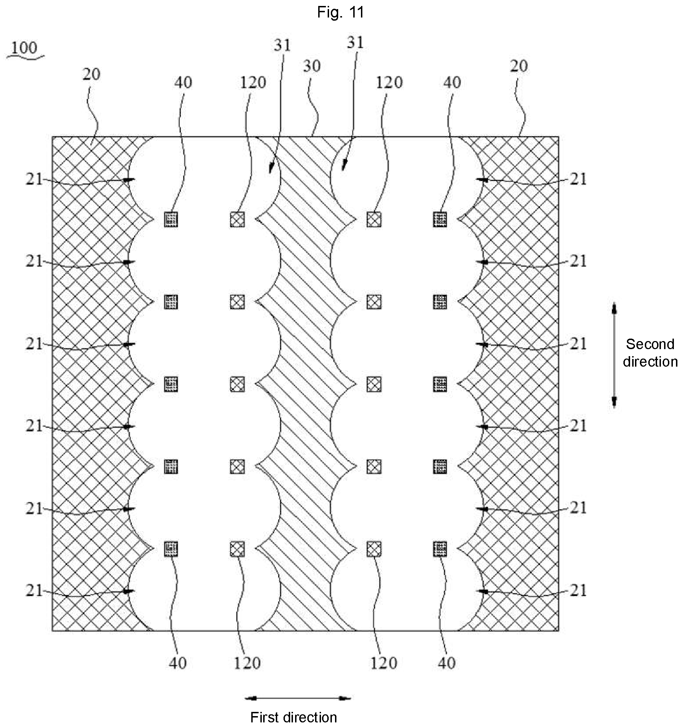

With reference to Fig. 11, in some examples, a plurality of second arc-shaped concave zones 31 are formed on side wall surfaces of the second polarity doped layers 30 adjacent to the spacing zones 123, the plurality of second arc-shaped concave zones 31 are configured in the second direction, the two adjacent second arc-shaped concave zones 31 intersect with each other, and the fifth isolated doped part 120 is arranged near a junction of the two adjacent second arc-shaped concave zones 31.

In this way, the arrangement of the second arc-shaped concave zones 31 is conducive to reduction in carrier recombination rate of the second polarity doped layers 30 near the spacing zones 123 and improvement in collection rate of the carriers. In addition, a manufacturing process of the second arc-shaped concave zones 31 is simple, and damage to the first polarity doped layers 20 is small, which is conducive to subsequent deposition of the back passivation film layer 50, thus improving passivation performance of the back contact solar cell 100. In addition, a field passivation effect can be further improved by arranging the fifth isolated doped part 120 near the junction of the two adjacent second arc-shaped concave zones 31.

Specifically, in the example, a shape of the second arc-shaped concave zones 31 may be a regular arc, such as an arc, or an irregular arc with different curvatures at different positions, which is not specifically limited herein. The case that the two adjacent first arc-shaped concave zones 31 intersect with each other means that the side wall surfaces of the second polarity doped layers 30 adjacent to the spacing zones 123 are composed of the plurality of first arc-shaped concave zones 31, that is, a contour of the side wall surfaces of the second polarity doped layers 30 adjacent to the spacing zones 123 is basically a wave-shaped curve.

In such an example, a distance between the fifth isolated doped part 120 and an intersection point of the two adjacent first arc-shaped concave zones 31 is greater than or equal to 300 nm.

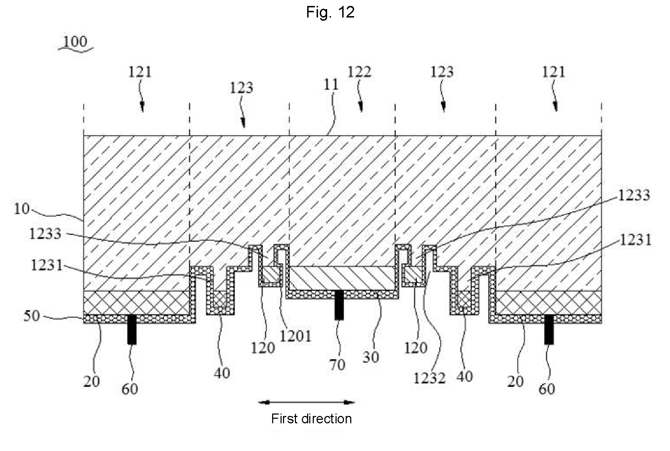

With reference to Fig. 12, in some examples, grooves 1232 are formed in the spacing zones 123, the grooves 1232 are internally provided with second isolated protrusions 1233, and the fifth isolated doped parts 120 are arranged on the second isolated protrusions 1233 and cover at least partial zones of the second isolated protrusions 1233.

In this way, through the arrangement of the grooves 1232 and the second isolated protrusions 1233, an isolation effect between the first polarity doped layers 20 and the second polarity doped layers 30 can be further improved, and a subsequent passivation effect of the back passivation film layer 50 can be improved.

Specifically, in such an example, in the example of the present disclosure, the spacing zones 123 and the second zones 122 are recessed further into the silicon wafer 10 than the first zones 121, and surfaces of the first isolated protrusions 1231 may be flush with surfaces of the first polarity doped layers 20. In one possible example, in a manufacturing process, the first polarity doped layers 20 may be deposited on the entire back surface 12 of the silicon wafer 10, and then the first polarity doped layers 20 in some zones may be removed through etching (laser etching, wet etching, etc.), such that the plurality of first polarity doped layers 20 arranged in the first direction are formed, and some independent first isolated doped parts 40 are left. It may be understood that in a removal process, recesses may be formed on the silicon wafer 10, and the first isolated protrusions 1231 protruding relative to the recesses may be formed below the first isolated doped parts 40.

Then, the second polarity doped layers 30 may be manufactured in the recesses, and then the second polarity doped layers 30 may be partially removed (through laser etching, wet etching, etc.) to form the grooves 1232 and form the independent second isolated protrusions 1233 and the fifth isolated doped parts 120 in the grooves 1232. In this way, zones corresponding to the first polarity doped layers 20 are the first zones 121, zones corresponding to the second polarity doped layers 30 are the second zones 122, and zones between zones where the first polarity doped layers 20 are located and zones where the second polarity doped layers 30 are located are the spacing zones 123. The silicon wafer 10 is provided with the first isolated protrusions 1231 and the second isolated protrusions 1233 in the spacing zones 123, the first isolated doped parts 40 are arranged on the first isolated protrusions 1231, and the fifth isolated doped parts 120 are arranged on the second isolated protrusions 1233. Clearly, it may be understood that in other examples, the back contact solar cell 100 may be manufactured in another mode, which is not specifically limited herein, as long as a structure corresponding to the present disclosure can be formed.

In some examples, the fifth isolated doped parts 120 only cover partial zones of the second isolated protrusions 1233.

In this way, sections of the fifth isolated doped parts 120 can be prevented from being exposed at sections of the grooves 1232, and recombination of space charge zones can be reduced.

With reference to Fig. 12, in some other examples, the fifth isolated doped parts 120 completely cover the second isolated protrusions 1233, and the fifth isolated doped parts 120 have second suspended sections 1201 extending out of the second isolated protrusions 1233 and suspended in the spacing zones 123. Specifically, the second suspended sections 1201 are suspended above the grooves 1232.

In this way, the fifth isolated doped parts 120 have the second suspended sections 1201 extending and suspended above the spacing zones 123, and spaced and opposite deposition zones are configured between the second suspended sections 1201 and the silicon wafer 10. In a subsequent deposition process of the back passivation film layer 50, the arrangement of the deposition zones may inhibit full exchange of plasma components in the zones and those outside the zones, thus implementing localized distribution of movable hydrogen contents of the back passivation film layer 50 on the back surface 12. In this way, the movable hydrogen contents of the back passivation film layer 50 in the deposition zones are smaller, and the movable hydrogen contents of the back passivation film layer 50 in other zones are greater, such that optimal passivation and attenuation resistance effects are achieved. Meanwhile, direct bombardment of plasma on the silicon wafer and bombardment damage can be reduced.

Specifically, in such an example, the second suspended sections 1201 may extend in any direction and be suspended above the grooves 1232. Specifically, an extension direction of the second suspended sections 1201 is not limited. An extension length of the second suspended sections 1201 relative to the second isolated protrusions 1233 may be any value of 0.2 µm to 50 µm. The extension length of the second suspended sections 1201 relative to the second isolated protrusions 1233 may be 0.2 µm to 50 µm, and for instance, one of 0.2 µm, 0.4 µm, 0.6 µm, 0.8 µm, 1 µm, 2 µm, 3 µm, 4 µm, 5 µm, 6 µm, 7 µm, 8 µm, 9 µm, 10 µm, 20 µm, 30 µm, 40 µm, and 50 µm.

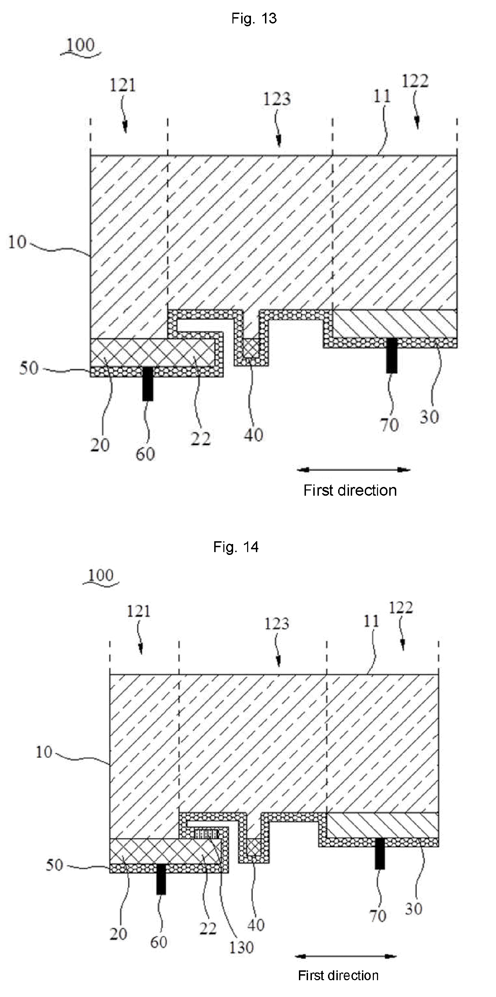

With reference to Fig. 13, in some examples, on at least part of the first polarity doped layers 20, the first polarity doped layers 20 have third suspended sections 22 extending to positions above the spacing zones 123, the third suspended sections 22 are suspended above part of the spacing zones 123, and the first isolated doped parts 40 are arranged on zones, not shielded by the third suspended sections 22, of the spacing zones 123.

In this way, through the arrangement of the third suspended sections 22, spaced and opposite deposition zones are configured between the third suspended sections 22 and the spacing zones 123. In a subsequent deposition process of the back passivation film layer 50, the arrangement of the deposition zones may inhibit full exchange of plasma components in the zones and those outside the zones, thus implementing localized distribution of movable hydrogen contents of the back passivation film layer 50 on the back surface 12. In this way, the movable hydrogen contents of the back passivation film layer 50 in the deposition zones are smaller, and the movable hydrogen contents of the back passivation film layer 50 in other zones are greater, such that optimal passivation and attenuation resistance effects are achieved. Meanwhile, direct bombardment of plasma on the silicon wafer and bombardment damage can be reduced.

With reference to Fig. 14, in some examples, surfaces of the third suspended sections 22 facing the silicon wafer 10 are provided with sixth isolated doped parts 130, and polarities of the sixth isolated doped parts 130 are the same as the polarities of the second polarity doped layers 30.

In this way, the sixth isolated doped parts 130 having different polarities are arranged on the surfaces of the third suspended sections 22 facing the silicon wafer 10, such that a passivation effect on the third suspended sections 22 can be improved, and a passivation effect on the entire spacing zones 123 can be further improved.

Specifically, in such an example, the sixth isolated doped parts 130 located on the third suspended sections 22 may be an integrated and continuous single doped part, or the plurality of independent sixth isolated doped parts 130 are provided on the third suspended sections 22. In such an example, the sixth isolated doped parts 130 may be in direct contact with the third suspended sections 22 or be insulated from the third suspended sections 22.

In some examples, the third suspended sections 22 may extend to zones, shielded by the third suspended sections 22, of the silicon wafer 10, thus further enhancing a passivation effect of the spacing zones 123.

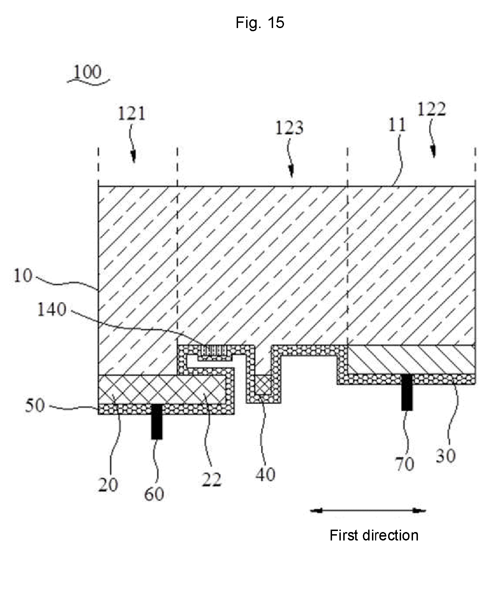

With reference to Fig. 15, in some examples, the zones, shielded by the third suspended sections 22, of the silicon wafer 10 are provided with seventh isolated doped parts 140, polarities of the seventh isolated doped parts 140 are the same as the polarities of the second polarity doped layers 30, and the seventh isolated doped parts 140 are spaced from the first polarity doped layers 20 and the second polarity doped layers 30. That is, the seventh isolated doped parts 140 are not in contact with the first polarity doped layers 20 and the second polarity doped layers 30.

In this way, the seventh isolated doped parts 140 are in contact with the silicon wafer 10 and are not in contact with the first polarity doped layers 20 and the second polarity doped layers 30, such that the seventh isolated doped parts 140 having different polarities are arranged while the first isolated doped parts 40 are arranged, and the first isolated doped parts 40 and the seventh isolated doped parts 140 may form field passivation in the spacing zones 123. Thus, a passivation effect is improved. Moreover, the arrangement of the first isolated doped parts 40 and the seventh isolated doped parts 140 can improve a collection rate of holes and electrons.

Specifically, when a doping type of the first isolated doped parts 40 is P-type doping and a doping type of the seventh isolated doped parts 140 is N-type doping, hole carriers are saturated at the first isolated doped parts 40, which may generate a repulsive force to subsequent hole carriers, such that the hole carriers can be collected by the first polarity doped layers 20 more quickly. Electron carriers are saturated at the seventh isolated doped parts 140, which may generate a repulsive force to subsequent electrons, such that the electrons can be collected by the second polarity doped layers 30 more quickly. In this way, a probability of recombination of holes and electrons in the spacing zones 123 is reduced, thus improving a collection rate of the carriers and further improving efficiency of the back contact solar cell 100.

Similarly, when a doping type of the first isolated doped parts 40 is N-type doping and a doping type of the seventh isolated doped parts 140 is P-type doping, electron carriers are saturated at the first isolated doped parts 40, which may generate a repulsive force to subsequent electron carriers, such that the electron carriers can be collected by the first polarity doped layers 20 more quickly. Hole carriers are saturated at the seventh isolated doped parts 140, which may generate a repulsive force to subsequent holes, such that the holes can be collected by the second polarity doped layers 30 more quickly. In this way, large recombination of holes and electrons in the spacing zones 123 is avoided, thus improving a collection rate of the carriers and further improving efficiency of the back contact solar cell 100.

That is, the arrangement of the first isolated doped parts 40 and the seventh isolated doped parts 140 can improve a collection rate of holes and electrons at the spacing zones 123, thus improving efficiency of the back contact solar cell 100.

Further, in such an example, the seventh isolated doped parts 140 are preferably spaced from the first isolated doped parts 40. That is, preferably, the seventh isolated doped parts 140 are not in contact with the first isolated doped parts 40. In this way, the seventh isolated doped parts 140 are arranged to be not in contact with the first isolated doped parts 40, such that a collection rate of holes and electrons can be further improved, and efficiency of the back contact solar cell 100 can be further improved.

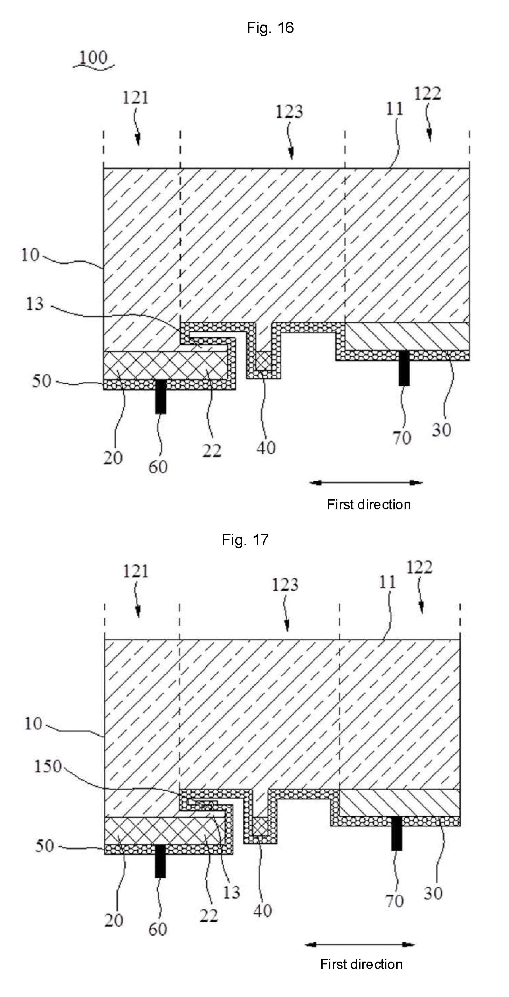

With reference to Fig. 16, in some examples, the silicon wafer 10 is provided with silicon wafer extending parts 13 extending to the spacing zones 123 and suspended in the spacing zones 123, and at least part of the third suspended sections 22 are stacked on the silicon wafer extending parts 13.

In this way, through the arrangement of the silicon wafer extending parts 13, the third suspended sections 22 can be prevented from breaking in a manufacturing process and falling into the spacing zones 123 to cause defects, and further full exchange of plasma components in the zones and those outside the zones can be inhibited, such that optimal passivation and attenuation resistance effects are achieved. Meanwhile, direct bombardment of plasma on the silicon wafer and bombardment damage can be further reduced.

With reference to Fig. 17, in some examples, surfaces of the silicon wafer extending parts 13 facing away from the third suspended sections 22 are provided with eighth isolated doped parts 150, and polarities of the eighth isolated doped parts 150 are the same as the polarities of the second polarity doped layers 30.

In this way, the eighth isolated doped parts 150 are arranged on the silicon wafer extending parts 13, such that a passivation effect on the silicon wafer extending parts 13 can be improved, and further a passivation effect on the entire spacing zones 123 can be improved. Meanwhile, the arrangement of the eighth isolated doped parts 150 may form floating junction passivation, thus further improving a collection rate of carriers.

In some examples, the eighth isolated doped parts 150 may preferably be spaced from the first isolated doped parts 40, thus further optimizing a collection rate of carriers of the back contact solar cell 100.

In the description, reference to at least one of terms such as "some examples", "illustrative example", "instance", "specific instance", or "some instances" means that specific features, structures, materials, or characteristics described in conjunction with the examples or instances are included in at least one of the examples or instances of the present disclosure. In the description, the illustrative description of the above terms does not necessarily refer to an identical example or instance. Moreover, at least one of specific features, structures, materials or characteristics described herein may be combined in a suitable way in any one or more examples or instances.

In addition, what are described above are merely preferred examples of the present disclosure, and not intended to limit the present disclosure. Any modifications, equivalent replacements, improvements, etc. made within the spirit and principle of the present disclosure should fall within the protection scope of the present disclosure.

## Claims

1. A back contact solar cell, comprising:
a silicon wafer, wherein the silicon wafer has a front surface and a back surface opposite each other, the back surface comprises first zones and second zones that are alternately and sequentially configured in a first direction in a spaced manner, the first zones and the second zones extend in a second direction, spacing zones are configured between adjacent the first zones and the second zones, and the second direction intersects with the first direction;
first polarity doped layers stacked on the first zones;
second polarity doped layers stacked on the second zones, wherein polarities of the second polarity doped layers are different from polarities of the first polarity doped layers; and
a plurality of first isolated doped parts, wherein the plurality of first isolated doped parts are independently arranged in the spacing zones and are spaced from the first polarity doped layers and the second polarity doped layers, and polarities of the first isolated doped parts are the same as the polarities of the first polarity doped layers.

2. The back contact solar cell according to claim 1, wherein in the first direction, a distance between the first isolated doped parts and the first polarity doped layers is greater than or equal to 300 nm.

3. The back contact solar cell according to claim 1, wherein in the first direction, a distance between the first isolated doped parts and the second polarity doped layers is greater than or equal to 300 nm.

4. The back contact solar cell according to claim 1, wherein the plurality of first isolated doped parts are randomly distributed and arranged on the spacing zones; or
the plurality of first isolated doped parts are arranged on the spacing zones in the second direction in a spaced manner.

5. The back contact solar cell according to claim 4, wherein in a case that the plurality of first isolated doped parts are arranged on the spacing zones in the second direction in a spaced manner, a distance between two adjacent the first isolated doped parts is 30 µm to 380 µm in the second direction.

6. The back contact solar cell according to claim 1, wherein a ratio of an orthographic projection area of all the first isolated doped parts in the single spacing zone in a thickness direction of the silicon wafer to an orthographic projection area of the single spacing zone in the thickness direction of the silicon wafer is 0.0001 to 0.5.

7. The back contact solar cell according to claim 6, wherein a ratio of an orthographic projection area of all the first isolated doped parts in the single spacing zone in a thickness direction of the silicon wafer to an orthographic projection area of the single spacing zone in the thickness direction of the silicon wafer is 0.001 to 0.1.

8. The back contact solar cell according to claim 1, wherein a thickness of the first isolated doped parts is 20 nm to 450 nm.

9. The back contact solar cell according to claim 1, wherein a plurality of first arc-shaped concave zones are formed on side wall surfaces of the first polarity doped layers adjacent to the spacing zones, the plurality of first arc-shaped concave zones are configured in the second direction, two adjacent the first arc-shaped concave zones intersect with each other, and the first isolated doped part is arranged near a junction of the two adjacent the first arc-shaped concave zones.

10. The back contact solar cell according to claim 1, wherein in the spacing zones, the silicon wafer is provided with first isolated protrusions, and the first isolated doped parts are arranged on the first isolated protrusions and cover at least partial zones of the first isolated protrusions.

11. The back contact solar cell according to claim 10, wherein the first isolated doped parts completely cover the first isolated protrusions, and the first isolated doped parts have first suspended sections extending out of the first isolated protrusions and suspended in the spacing zones.

12. The back contact solar cell according to claim 11, wherein surfaces of the first suspended sections facing the silicon wafer are provided with second isolated doped parts, and polarities of the second isolated doped parts are different from the polarities of the first polarity doped layers and are the same as the polarities of the second polarity doped layers.

13. The back contact solar cell according to claim 12, wherein the second isolated doped parts are insulated from the first suspended sections.

14. The back contact solar cell according to claim 12, wherein the second isolated doped parts further extend along side surfaces of the first isolated protrusions to zones, shielded by the first suspended sections, of the silicon wafer.

15. The back contact solar cell according to claim 11, wherein side surfaces of the first isolated protrusions are provided with third isolated doped parts, and the third isolated doped parts are spaced from the first isolated doped parts.

16. The back contact solar cell according to claim 11, wherein zones, shielded by the first suspended sections, of the silicon wafer are provided with fourth isolated doped parts, polarities of the fourth isolated doped parts are the same as the polarities of the second polarity doped layers, and the fourth isolated doped parts are spaced from the first polarity doped layers and the second polarity doped layers.

17. The back contact solar cell according to claim 16, wherein the fourth isolated doped parts are spaced from the first isolated protrusions and the first isolated doped parts.

18. The back contact solar cell according to claim 17, wherein in the first direction, a distance between the fourth isolated doped parts and the first isolated protrusions is 0.1 µm to 200 µm.

19. The back contact solar cell according to claim 1, further comprising a plurality of fifth isolated doped parts, wherein the plurality of fifth isolated doped parts are arranged in the spacing zones, the fifth isolated doped parts are spaced from the first polarity doped layers and the second polarity doped layers, and polarities of the fifth isolated doped parts are the same as the polarities of the second polarity doped layers.

20. The back contact solar cell according to claim 19, wherein the fifth isolated doped parts are spaced from the first isolated doped parts in the spacing zones.

21. The back contact solar cell according to claim 20, wherein a distance between any one of the fifth isolated doped parts and any one of the first isolated doped parts is greater than or equal to 0.1 µm to 200 µm.

22. The back contact solar cell according to claim 19, wherein in the first direction, a distance between the fifth isolated doped parts and the second polarity doped layers is greater than or equal to 300 nm.

23. The back contact solar cell according to claim 19, wherein in the first direction, a distance between the fifth isolated doped parts and the first polarity doped layers is greater than or equal to 300 nm.

24. The back contact solar cell according to claim 19, wherein the plurality of fifth isolated doped parts are randomly distributed and arranged on the spacing zones; or
the plurality of fifth isolated doped parts are arranged on the spacing zones in the second direction in a spaced manner.

25. The back contact solar cell according to claim 21, wherein in a case that the plurality of fifth isolated doped parts are arranged on the spacing zones in the second direction in a spaced manner, a distance between two adjacent the fifth isolated doped parts is 30 µm to 380 µm.

26. The back contact solar cell according to claim 19, wherein a ratio of an orthographic projection area of all the fifth isolated doped parts in the single spacing zone in a thickness direction of the silicon wafer to an orthographic projection area of the single spacing zone in the thickness direction of the silicon wafer is 0.0001 to 0.5.

27. The back contact solar cell according to claim 26, wherein a ratio of an orthographic projection area of all the fifth isolated doped parts in the single spacing zone in a thickness direction of the silicon wafer to an orthographic projection area of the single spacing zone in the thickness direction of the silicon wafer is 0.001 to 0.1.

28. The back contact solar cell according to claim 19, wherein a thickness of the fifth isolated doped parts is 20 nm to 450 nm.

29. The back contact solar cell according to claim 19, wherein a plurality of second arc-shaped concave zones are formed on side wall surfaces of the second polarity doped layers adjacent to the spacing zones, the plurality of second arc-shaped concave zones are configured in the second direction, two adjacent the second arc-shaped concave zones intersect with each other, and the fifth isolated doped parts are arranged near a junction of the two adjacent the second arc-shaped concave zones.

30. The back contact solar cell according to claim 19, wherein grooves are formed in the spacing zones, the grooves are internally provided with second isolated protrusions, and the fifth isolated doped parts are arranged on the second isolated protrusions and cover at least partial zones of the second isolated protrusions.

31. The back contact solar cell according to claim 30, wherein the fifth isolated doped parts only cover partial zones of the second isolated protrusions; or
the fifth isolated doped parts completely cover the second isolated protrusions, and the fifth isolated doped parts have second suspended sections extending out of the second isolated protrusions and suspended in the spacing zones.

32. The back contact solar cell according to claim 1, wherein on at least part of the first polarity doped layers, the first polarity doped layers have third suspended sections extending to positions above the spacing zones, the third suspended sections are suspended above part of the spacing zones, and the first isolated doped parts are arranged on zones, not shielded by the third suspended sections, of the spacing zones.

33. The back contact solar cell according to claim 32, wherein surfaces of the third suspended sections facing the silicon wafer are provided with sixth isolated doped parts, and polarities of the sixth isolated doped parts are the same as the polarities of the second polarity doped layers.

34. The back contact solar cell according to claim 32, wherein zones, shielded by the third suspended sections, of the silicon wafer are provided with seventh isolated doped parts, the seventh isolated doped parts are spaced from the first polarity doped layers and the second polarity doped layers, and polarities of the seventh isolated doped parts are the same as the polarities of the second polarity doped layers.

35. The back contact solar cell according to claim 34, wherein the seventh isolated doped parts are spaced from the first isolated doped parts.

36. The back contact solar cell according to claim 32, wherein the silicon wafer is provided with silicon wafer extending parts extending to the spacing zones and suspended in the spacing zones, and at least part of the third suspended sections are stacked on the silicon wafer extending parts.

37. The back contact solar cell according to claim 36, wherein surfaces of the silicon wafer extending parts facing away from the third suspended sections are provided with eighth isolated doped parts, and polarities of the eighth isolated doped parts are the same as the polarities of the second polarity doped layers.

38. The back contact solar cell according to claim 37, wherein the eighth isolated doped parts are spaced from the first isolated doped parts.

39. A cell assembly, comprising the back contact solar cell according to any one of claims 1 to 38.

40. A photovoltaic system, comprising the cell assembly according to claim 39.
